(19) Europäisches Patentamt
European Patent Office
Office européen des brevets

(11) Numéro de publication: **0 010 023**
**B1**

(12) **FASCICULE DE BREVET EUROPEEN**

(45) Date de publication du fascicule du brevet: **08.11.89**

(51) Int. Cl.⁴: **H 04 N 5/40**

(21) Numéro de dépôt: **79400656.9**

(22) Date de dépôt: **18.09.79**

(54) **Système de transmission en modulation d'amplitude à haute performance et émetteur et réémetteur de télévision comportant un tel système.**

(30) Priorité: **22.09.78 FR 7827255**

(43) Date de publication de la demande: **16.04.80 Bulletin 80/8**

(45) Mention de la délivrance du brevet: **08.11.89 Bulletin 89/45**

(84) Etats contractants désignés: **AT BE CH DE GB IT LU NL SE**

(56) Documents cités: **GB-A- 527 102**

(73) Titulaire: **THOMSON-LGT LABORATOIRE GENERAL DES TELECOMMUNICATIONS, 51, boulevard de la République, F-78400 Chatou (FR)**

(72) Inventeur: **Chemin, Henri, Thomson-CSF - SCPI 173, bld Haussmann, F-75360 Paris Cedex 08 (FR)**
Inventeur: **Cluniat, Claude, Thomson-CSF - SCPI 173, bld Haussmann, F-75360 Paris Cedex 08 (FR)**
Inventeur: **Beltzer, Bernard, Thomson-CSF - SCPI 173, bld Haussmann, F-75360 Paris Cedex 08 (FR)**

(74) Mandataire: **Courtellemont, Alain et al, THOMSON-CSF SCPI, F-92045 PARIS LA DEFENSE CEDEX 67 (FR)**

**EP 0 010 023 B1**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen)

**Description**

La présente invention concerne les systèmes de transmission en modulation d'amplitude et plus particulièrement les émetteurs et les réémetteurs de télévision en noir et blanc ou en couleurs.

On sait que tout émetteur à modulation d'amplitude doit satisfaire à des conditions de linéarité de l'amplitude du signal modulé par rapport à celle du signal de modulation. Le traité d'électronique des «Techniques de l'Ingénieur», fiche E 6110, concernant les émetteurs de télévision, décrit les principes actuellement utilisés, en particulier pour l'amplification de puissance: un signal porteur modulé issu d'un modulateur est amplifié, dans sa totalité par des amplificateurs à semi-conducteurs jusqu'à 40 W, après quoi l'amplification nécessaire pour arriver à la puissance finale d'émission est réalisée, toujours sur le signal pris dans sa totalité, par un amplificateur à faible rendement à tube.

Lorsque l'émetteur de télévision transmet une porteuse modulée avec un courant porteur au niveau nominal, pour que la modulation ne subisse pas de distorsion et que les conditions de linéarité soient satisfaites, il est nécessaire de régler le niveau d'entrée des amplificateurs de puissance, en crête de modulation, nettement en dessous du niveau de saturation, l'écart n'étant pas inférieur à 2 ou 33 dB pour un amplificateur de puissance commun aux signaux audio et vidéofréquence, même compte tenu des dispositifs de correction de linéarité. Ainsi l'étage de puissance n'introduit pas de distorsion. En contrepartie, le rendement global en crête est très faible, de l'ordre de 18% en ondes métriques et décimétriques, par exemple. Il en résulte une limitation sévère de la puissance d'émission maximale possible avec des amplificateurs de puissance en version transistorisée.

La présente invention a pour objet un système de transmission en modulation d'amplitude dans lequel le rendement des amplificateurs de puissance est notablement augmenté sans que les conditions de linéarité soient dégradées.

Pour cela au lieu d'amplifier la porteuse modulée, avec son niveau nominal de courant porteur dans un étage amplificateur de puissance à faible rendement, afin d'obtenir la puissance nécessaire sans que le signal modulant la porteuse soit distordu, l'étage de puissance du système de transmission selon l'invention amplifie séparément une porteuse modulée ayant un niveau de signal porteur réduit par rapport au niveau nominal et une porteuse pure non modulée, ces deux signaux étant additionnés à la sortie de l'étage de puissance. Les niveaux crête de la porteuse modulée à porteur réduit et de la porteuse pure sont ajustés afin de reconstituer en sortie le niveau nominal.

Il est connu de réaliser des modulateurs à porteur supprimé qui fournissent seulement les bandes latérales de modulation. Il est également connu, par exemple par le brevet anglais n° 527 102, d'associer à un tel modulateur à porteur supprimé un dispositif pour réintroduire un courant porteur proportionnel à l'amplitude des bandes de modulation, afin de transmettre la teinte moyenne de l'image. Le signal résultant issu de ce modulateur est le signal porteur modulé qui doit ensuite être traité avant émission, par une éventuelle transposition à la fréquence d'émission, puis par une amplification de puissance pour obtenir la puissance d'émission nécessaire.

Comme indiqué ci-dessus, le système suivant l'invention dissocie également le signal de télévision en un signal porteur modulé à niveau de courant porteur réduit et un signal porteur pur non modulé, mais pour les amplifier séparément dans des amplificateurs de puissance, les signaux de sortie de ces amplificateurs étant réunis au moyen d'un circuit de couplage de puissance.

Selon l'invention, un système de transmission en modulation d'amplitude de signal de télévision comportant un générateur de signal modulé fournissant sur une première sortie un signal porteur modulé par l'information vidéofréquence et sur une seconde sortie un signal porteur modulé par le signal audiofréquence, et comportant en outre un étage d'amplification de puissance, est caractérisé en ce que le signal porteur modulé par l'information vidéofréquence a un niveau de porteur moins élevé que le niveau nominal, en ce que le générateur fournit sur une troisième sortie un signal porteur non modulé ayant un niveau prédéfini par rapport au niveau du signal porteur modulé par l'information vidéofréquence, un circuit de traitement étant prévu pour fixer le niveau prédéfini et la phase du signal porteur non modulé, en ce que l'étage d'amplification de puissance comporte une première voie d'amplification reliée à la sortie de signal porteur modulé par l'information vidéofréquence et une seconde voie d'amplification, indépendante de la première, reliée à la sortie de signal porteur non modulé, et en ce qu'un circuit de couplage de puissance réunit les signaux issus de ces deux voies pour fournir le signal modulé amplifié en puissance.

L'invention sera mieux comprise et d'autres caractéristiques apparaîtront à l'aide de la description ci-après et des dessins s'y rapportant sur lesquels:

- la figure 1 est un exemple de réalisation d'un émetteur de télévision comportant un système de transmission selon l'invention;
- les figures 2, 4 et 5 concernant les modes de réalisation d'organes de la figure 1;
- les figures 3a à 3f sont des diagrammes explicatifs;
- les figures 6 et 7 représentent des variantes de l'émetteur représenté figure 1;
- la figure 8 représente le schéma d'une partie d'un réémetteur de télévision comportant un système de télévision selon l'invention.

Tout repère commun à plusieurs figures concerne un même organe.

Sur la figure 1, un dispositif modulateur 1 comporte un circuit de modulation de signaux vidéofréquence 2 et un modulateur de signaux audiofréquence 3 recevant respectivement, sur une première entrée 4, le signal image, et sur une première entrée 5, le signal sonore d'un programme de télévision, les secondes entrées de ces modulateurs recevant en parallèle le signal fourni sur la borne de sortie 6 d'un générateur de signal porteur à fréquence intermédiaire 7, qui alimente également un circuit de traitement 15 comportant un atténuateur ajustable 16 en série avec un déphaseur ajustable 17.

La sortie 12 du circuit de modulation 2 alimente une première voie d'amplification comportant un mélangeur 9 suivi d'un amplificateur 19 dont la sortie 26 est connectée à une première entrée d'un dispositif sommateur 23.

De même la sortie 14 du circuit 15 alimente une deuxième voie d'amplification comportant un mélangeur 11 suivi d'un amplificateur 21 dont la sortie 28 est connectée à une deuxième entrée du dispositif 23.

Enfin, dans ce mode de réalisation, la sortie 13 du modulateur 3 alimente une troisième voie d'amplification comportant un mélangeur 10 suivi d'un amplificateur 20 ayant une sortie 27 connectée à une troisième entrée du dispositif 23 dont la sortie 24 est celle du système de transmission.

Chacun des mélangeurs 9, 10 et 11 présente une entrée supplémentaire; toutes trois sont reliées en parallèle à un générateur de fréquence de transposition 18.

L'ensemble décrit constitue un émetteur de télévision à voies séparées image et son qui se distingue des structures connues par la deuxième voie (mélangeur 11, amplificateur 21) qui fournit le signal porteur vidéofréquence non modulé, à la fréquence d'émission finale, avec une amplitude et une phase respectivement ajustées par l'atténuateur 16 et le déphaseur 17 avant d'être additionnée, dans le sommateur 23, au signal modulé généré par le modulateur 2 avec un niveau réduit de porteuse.

La sortie du sommateur 23 restitue ainsi en sortie le spectre du signal de télévision standard.

L'intérêt d'une telle disposition sera montré à partir de la description suivante d'un exemple de réalisation du circuit de modulation 2 et du sommateur 23.

Sur la figure 2, le circuit de modulation 2 est constitué d'un modulateur en anneau comportant un transformateur 30, dont le primaire asymétrique reçoit le signal porteur à fréquence intermédiaire appliqué à la borne d'entrée 6, un transformateur 31 dont le secondaire asymétrique est relié à la borne de sortie 12 commune au circuit 2 et au dispositif de modulation 1 (figure 1). Entre le secondaire symétrique du transformateur 30, d'extrémités 32 et 33 et de point milieu 36, et le primaire symétrique du transformateur 31, d'extrémités 34 et 35 et de point milieu 37, sont montées quatre diodes semi-conductrices, 38 à 41 comme indiqué sur la figure 1, selon la disposition adoptée dans tous les modulateurs en anneau classiques. Une source de tension continue ajustable 48 est connectée au point milieu 36 et le signal modulant vidéo au point milieu 37 à partir de la borne d'entrée 4.

Il est d'abord supposé qu'il y a une différence de potentiel nulle entre les points 36 et 37 du modulateur. Une tension alternative appliquée en 6, développera deux tensions à chaque instant égales, et opposées en signe, respectivement à chaque extrémité 32 ou 33 du secondaire du transformateur 30, ce qui provoque, à l'une des bornes 34 ou 35, l'apparition simultanée de deux tensions égales et opposées. Ces dernières apparaîtront, par exemple, à la borne 35, à travers les diodes 38 et 40 qui seront toutes deux conductrices, à l'instant où la borne 32 est le siège d'une tension négative et la borne 33 celle d'une tension égale et opposée.

Ainsi aucun signal ne sera délivré sur la borne de sortie 12.

Si une tension U, par exemple positive, est appliquée au point 37 par rapport au point 36, et si le signal appliqué à l'entrée 6 a une amplitude supérieure à cette tension, les diodes 38 et 41 seront conductrices et les diodes 39 et 40 bloquées pour toute valeur absolue instantanée du signal d'entrée, égale ou inférieure à U, qui est ainsi transmise en phase entre les extrémités 35 et 34, par rapport à la tension présente entre les extrémités 32 et 33. Lorsque la valeur absolue du signal d'entrée dépasse la valeur U, les diodes sont alternativement bloquées ou conductrices au gré de la polarisation du signal d'entrée, le fonctionnement précédemment décrit a lieu, et toute augmentation de tension au-dessus de U est annulée par mise en opposition de tension égales.

Ainsi il est recueilli sur la borne de sortie 12 un signal de fréquence intermédiaire écrêté, d'amplitude égale ou proportionnelle à U (en fonction du rapport de transformation du transformateur 31) et qui est en phase avec le signal d'entrée si U est positif (diodes 38 et 41 conductrices), et en opposition de phase si U est négatif.

Le fonctionnement obtenu en superposant un signal vidéofréquence à cette tension continue sera expliqué à partir des diagrammes de la figure suivante.

Sur la figure 3, les figures 3a, 3b et 3c représentent un même signal vidéofréquence comportant deux impulsions de synchronisation 53 et 54 entre lesquelles la courbe de luminance 55 est supposée varier linéairement du noir absolu au blanc absolu. Les figures 3d, 3e et 3f représentent les signaux modulés obtenus sur la borne de sortie 12 du modulateur pour différentes valeurs de la tension continue fournie, par rapport à la masse, en sortie du générateur 48, le signal vidéofréquence étant supposé être un signal positif de niveau relatif: 0 au sommet de l'impulsion de synchronisation, 0,3 au palier de suppression 60, et 1 au niveau du blanc absolu 61.

Lorsque la tension fournie par le générateur 48 est nulle, ce qui est représenté par la ligne 50 (figure 3a) le potentiel du point 37 (figure 2) est constamment positif ou nul par rapport au point 36 pour tout point du signal vidéofréquence, il est alors obtenu le signal modulé représenté figure 3d qui correspond à la modulation positive classique, la phase du signal porteur étant en permanence en phase avec le signal d'entrée (diodes 38 et 41

conductrices pour toute valeur absolue instantanée de la tension d'entrée inférieure à celle du signal de modulation appliquée au même instant). L'amplitude du signal porteur en crête de modulation est de 1 (égale à celle du signal modulant).

Si la tension fournie par le générateur 48 est portée à 1, ce qui correspond à la ligne 51 de la figure 3b, le signal modulé représenté figure 3e est alors obtenu, il correspond, à l'inverse du précédent, 3d, à la modulation négative classique, la phase du signal porteur étant en permanence en opposition de phase avec le signal d'entrée (diodes 39 et 40 conductrices pour toute valeur absolue instantanée de la tension d'entrée inférieure à celle du signal de modulation appliquée au même instant).

Enfin dans le cas particulier de la figure 3c, qui sera plus particulièrement considérée par la suite, le générateur 48 délivre un niveau relatif 0,65, représenté par la ligne 52 qui passe par le milieu de la courbe de luminance 55, il est alors obtenu le signal modulé représenté par la figure 3f, signal à niveau réduit de porteuse où les niveaux de noir (60) et de blanc (61) modulent un signal porteur de phase opposé avec une même amplitude dont le niveau relatif est de 1–0,65 = 0,35, la crête du signal modulé atteignant 0,35 + 0,3 = 0,65.

Les figures montrent que le signal modulé de la figure 3e sera obtenu à partir du signal 3f en lui additionnant un signal porteur pur en opposition de phase avec le signal d'entrée et d'amplitude crête égale à 1–0,65 = 0,35.

De même le signal modulé de la figure 3d sera obtenu à partir de ce même signal 3f en lui additionnant un signal porteur non modulé, en phase avec le signal d'entrée, et d'amplitude crête égale à 1–0,35 = 0,65.

La figure suivante montre un exemple de réalisation du sommateur 23 qui réalise, en particulier, l'addition des signaux vidéofréquence modulé et non modulé.

Sur la figure 4, un diplexeur sélectif 70 reçoit sur chacune de ses deux entrées les signaux recueillis respectivement sur la sortie 27 de l'amplificateur 20 et la sortie 28 de l'amplificateur 21 (figure 1).

Un coupleur hybride 3 dB, 71, présente une première paire d'accès conjugués 72 et 73 connectés respectivement à la sortie 26 de l'amplificateur 19 (figure 1) et à la sortie du diplexeur 70, et une deuxième paire d'accès conjugués connectés respectivement à la sortie 24 du sommateur 23 et à une impédance de charge Z.

Le diplexeur sélectif 70 additionne sans pertes sensibles le signal porteur vidéofréquence pur et le signal modulé par les informations audiofréquence.

L'énergie de ce dernier signal, contenue dans les signaux appliqués à l'accès 73 est partagée en deux parties égales par le coupleur 71 entre la charge Z et la sortie 24. Une perte de 3 dB est ainsi occasionnée sur ces signaux.

En ce qui concerne la composition des porteurs vidéofréquence pur et modulé, qui sont de même fréquence, l'énergie perdue dans la charge Z est évidemment fonction de leur amplitude et phase relative. Il va être montré que cette perte de puissance est suffisamment faible pour que le bilan global soit intéressant et qu'une amélioration considérable du rendement soit obtenue pour l'émetteur complet.

On sait que les coupleurs 3 dB permettent d'obtenir sur les deux accès de l'une des paires d'accès conjugués, respectivement la somme et la différence algébrique des deux tensions appliquées respectivement sur les deux accès de l'autre paire à condition que leurs fréquences soient identiques, ce qui est le cas et leurs phases relatives égales à

$$\frac{\pi}{2} \pm k\pi ,$$

k étant un nombre entier positif, ce déphasage étant ajusté par le déphaseur 17. $U_1$ et $U_2$ étant les amplitudes des tensions appliquées à un instant donné respectivement aux accès 72 et 73 du coupleur 71, ce qui représente une puissance totale appliquée proportionnelle à la quantité $Q = U_1^2 + U_2^2$, on recueillera sur l'un des accès de l'autre paire une puissance proportionnelle à

$$A = \frac{(U_1 - U_2)^2}{2} \quad \text{et sur l'autre à} \quad B = \frac{(U_1 + U_2)^2}{2}.$$

Pour un rapport $\frac{U_1}{U_2} = C$

entre les amplitudes des signaux appliqués, et si la puissance B est recherchée à la sortie 24, le calcul montre qu'il faut:

$$U_1^2 = \frac{2AC^2}{C^2 - 2C + 1} \quad \text{et} \quad U_2^2 = \frac{2B}{C^2 + 2C + 1}$$

Par exemple, s'il est recherché de produire le signal de la figure 3e, à modulation négative avec une puissance de crête maximale unité, il faudra que B = 1 avec

$$C = \frac{0,65}{0,35} = 1,86$$

soit $U_1^2 = 0,845$ et $U_2^2 = 0,245$ ce qui représente une puissance totale appliquée de 1,09, donc seulement 0,4 dB environ de perte de puissance globale.

Il est à remarquer que le niveau de crête maximale du signal modulé en porteuse réduite, c'est-à-dire au sommet de l'impulsion de synchronisation, est ainsi, en sortie de l'amplificateur 19, de 15,4% inférieur à celui du même amplificateur fournissant le signal normal en modulation négative.

Mais il y a lieu de remarquer également que le bilan est encore plus intéressant au niveau du noir ou du blanc absolu en modulation négative.

$U_2^2$ est inchangé pour une même puissance de crête maximale unitaire et $U_1^2$, lui est ici égal, donc $U_1^1 = U_2^2 = 0,245$, avec une puissance dissipée nulle dans la charge.

Il en résulte que l'amplificateur de signaux modulés 19 délivrera dans ces conditions une puissance inférieure de moitié à celle qu'il délivrerait en modulation normale, où elle devrait être égale à $(0,7)^2 = 0,49$.

L'expérience montre également que la forme particulière du signal modulé de la figure 3f, où les niveaux du noir et du blanc absolus sont égaux, et celui du gris moyen est nul, se prête à une amplification en classe AB, avec un rendement très supérieur aux valeurs habituelles en modulation classique.

Alors qu'un émetteur classique présente en vidéofréquence, sur ondes métriques ou décimétriques, un rendement de 18% environ, ce qui, pour une puissance crête utile arbitraire égale à l'unité, représente une puissance d'alimentation de 5,5, le système selon l'invention délivre la même puissance de crête unitaire à partir d'une puissance utile de signal porteur pur égale à 0,245, obtenue en classe C par l'amplificateur 21 avec 65% du rendement, soit 0,38 de puissance d'alimentation correspondante, et à partir d'une puissance utile en crête de signal modulé, à niveau réduit de porteuse, de 0,845 qui est obtenue par l'amplificateur 19, en classe AB avec un rendement de 36% environ, soit 2,35 de puissance d'alimentation. Il en résulte ainsi, au total, une puissance d'alimentation de 2,73 et un rendement global de 36,5%, donc doublé par rapport aux structures classiques jusqu'ici utilisées.

Le rendement de l'émetteur, en exploitation, c'est-à-dire en transmission d'une image moyenne grise, est encore beaucoup plus amélioré du fait de l'utilisation d'étages de puissance en classe AB maintenant possible sur la voie modulée grâce à ces nouvelles dispositions.

En ce qui concerne la transmission des signaux audiofréquence, elle est effectuée par le sommateur 23 avec une perte de 3 dB. Cet inconvénient peut être éliminé par une structure objet de la figure suivante.

Sur la figure 5, le sommateur 23 comporte également le coupleur 3 dB, 71, et le diplexeur sélectif 70, mais les signaux vidéofréquence pur et modulé sont d'abord composés dans le coupleur 71 avant d'être diplexés à l'aide de circuits sélectifs dans le diplexeur 70. Les signaux audiofréquence ne subissent alors que des pertes résiduelles dues aux imperfections des organes utilisés.

Les critères du choix entre ces deux solutions ne sont pas influencés par l'utilisation d'une modulation à niveau réduit de porteuse, ils sont communs à ceux des émetteurs classiques pour lesquels on met en balance le coût et la précision de maintenance entraînés par un diplexeur sélectif, où transitent les signaux vidéofréquence, vis-à-vis d'un gain de 50% sur la puissance de l'émetteur son.

Les figures suivantes 6 et 7 montrent deux variantes de réalisation de l'émetteur de la figure 1 qui se caractérisent l'une et l'autre par la suppression de la voie d'amplification constituée du mélangeur 10 et de l'amplificateur 20 et par la simplification du sommateur 23 qui comporte seulement le coupleur 3 dB, 71, dont les accès 72 et 73 sont respectivement connectés à la sortie 26 de l'amplificateur 19 et à la sortie 28 de l'amplificateur 21.

Sur la figure 6, la sortie 13 du modulateur 3, qui alimentait la voie d'amplification supprimée, est maintenant connectée à une première entrée d'un sommateur 75, et la liaison entre la sortie 12 du circuit 2 et le mélangeur 9 s'effectue à travers une deuxième entrée et la sortie du sommateur 75.

La figure 7 ne diffère de la précédente que par le raccordement du sommateur 75 dont la seconde entrée est connectée à la sortie 14 du circuit de prélèvement 15, et la sortie à l'entrée du mélangeur 11, la liaison directe étant rétablie entre la sortie 12 du circuit 2 et le mélangeur 9.

L'une et l'autre structure présentent l'avantage d'une simplification intéressante des équipements.

Toutefois la structure de la figure 7 est un mode de réalisation préféré, elle permet en effet d'éviter les contraintes sévères de linéarité des émetteurs classiques à voie commune d'amplification pour l'image et le son puisque les signaux porteurs modulés audio et vidéofréquence sont isolés.

Tout ce qui a été dit de la composition des signaux porteurs vidéofréquence, pur et modulé, à l'occasion des figures 1 à 3, reste valable, en particulier les avantages concernant l'amélioration très sensible du rendement.

De plus les structures objet des figures 1, 6 et 7 sont intégralement applicables aux réemetteurs, au dispositif de modulation 1 près, dont un exemple de réalisation est décrit ci-après.

Sur la figure 8, le dispositif générateur 1 comporte un récepteur de télévision ayant une entrée 80, recevant les signaux à haute fréquence d'un aérien (non représenté), et alimentant en série un mélangeur 81, un amplificateur à fréquence intermédiaire 82, et un séparateur 83 dont une première sortie 84 fournit, sur la sortie 13 du dispositif, le signal porteur modulé par les signaux audiofréquence, et dont une seconde sortie 85 est reliée à l'entrée d'une variante du circuit de modulation 2. Cette entrée est connectée en parallèle à un dispositif d'écrêtage et de filtrage 86 et à la première entrée d'un additionneur 87 dont la sortie est reliée à la sortie 12 du dispositif 1. La sortie du dispositif 86 est connectée, d'une part, à la sortie 14 du dispositif 1 à travers le circuit de traitement 15, et d'autre part à la seconde entrée de l'additionneur 87 à travers un circuit de traitement 88 identique au circuit 15 déjà décrit.

Le dispositif 86 assure l'écrêtage et le filtrage du signal porteur modulé de manière classique, en positif ou négatif, par les signaux vidéofréquence, afin d'en extraire le signal porteur pur à destination, d'une part, de la voie d'amplification correspondante (mélangeur 11 et amplificateur 21 des figures 1, 6 et 7) et d'autre part du circuit 88. Le signal de sortie de ce circuit 88 permet à l'additionneur 87 de fournir sur sa sortie 12 un signal modulé à porteuse réduite, par exemple celui représenté sur la figure 3f par addition d'un signal porteur pur d'amplitude relative 0,35 en phase avec le signal d'entrée si le signal modulé reçu

sur l'accès 80 est du type de la figure 3e (modulation négative) ou d'amplitude 0,65 en opposition de phase avec le signal d'entrée s'il est du type de la figure 3d (modulation positive).

Ainsi il a été montré que le système selon l'invention, comportant essentiellement une amplification séparée, suivie d'une combinaison dans des conditions d'amplitude et de phase relatives déterminées, d'un signal porteur modulé en vidéofréquence à niveau porteur réduit et de ce même porteur non modulé, est applicable à tous les émetteurs et réémetteurs de signaux de télévision, quelque soit leur type de standard, qu'ils soient prévus pour les signaux noir et blanc, ou couleur, la sous-porteuse de chrominance n'étant qu'une composante du signal modulant vidéofréquence et traitée comme telle. Ce dispositif permet d'améliorer le rendement et en conséquence la fiabilité dans de grandes proportions par rapport aux émetteurs et réémetteurs connus.

Bien entendu les schémas décrits l'ont été à titre d'exemple et de nombreuses variantes de réalisation ou de répartition de niveaux sont possibles.

C'est ainsi qu'on peut adopter d'autres caractéristiques du signal modulé à porteuse réduite que celles correspondant à la figure 3f. S'il est souhaité une linéarité homogène de l'ensemble du signal, y compris les impulsions de synchronisation, il suffira de choisir une tension continue de +0,5 comme niveau de sortie de l'alimentation 48 de la figure 2 pour obtenir un niveau identique dans le blanc et aux sommets des impulsions de synchronisation.

D'autres modulateurs que celui montré figure 2 peuvent être utilisés. Il est bien connu que la plupart des modulateurs connus peuvent générer un signal modulé à porteuse réduite à l'aide d'un réglage approprié, qu'il arrive d'ailleurs fréquemment d'obtenir accidentellement lors de mauvais réglages d'exploitation des émetteurs classiques.

Enfin l'invention est également applicable aux émetteurs de télévision ne comportant pas de transposition de fréquence des signaux porteurs modulés ou non modulés qui ont alors une fréquence égale à la fréquence à émettre.

## Revendications

1. Système de transmission en modulation d'amplitude de signal de télévision comportant un générateur de signal modulé (1) fournissant sur une première sortie (12) un signal porteur modulé par l'information vidéofréquence et sur une seconde sortie (13) un signal porteur modulé par le signal audiofréquence, et comportant en outre un étage d'amplification de puissance, caractérisé en ce que le signal porteur modulé par l'information vidéofréquence a un niveau de porteur moins élevé que le niveau nominal, en ce que le générateur (1) fournit sur une troisième sortie (14) un signal porteur non modulé ayant un niveau prédéfini par rapport au niveau du signal porteur modulé par l'information vidéofréquence, un circuit de traitement (15) étant prévu pour fixer le niveau prédéfini et la phase du signal porteur non modulé, en ce que l'étage d'amplification de puissance comporte une première voie d'amplification reliée à la sortie (12) de signal porteur modulé par l'information vidéofréquence et une seconde voie d'amplification indépendante de la première reliée à la sortie (14) de signal porteur non modulé, et en ce qu'un circuit de couplage de puissance (23) réunit les signaux issus de ces deux voies pour fournir le signal modulé amplifié en puissance.

2. Système de transmission selon la revendication 1, caractérisé en ce que, la première et la deuxième voie d'amplification comportant chacune un mélangeur (9, 11) en série avec un amplificateur (19, 21), l'étage final de l'amplificateur (19) de la première voie appartient à la classe AB et celui (21) de la deuxième voie à la classe B ou C.

3. Système de transmission selon la revendication 2, caractérisé en ce que le circuit de traitement comporte un déphaseur ajustable (17) en série avec un atténuateur ajustable (16) et en ce que le circuit de couplage de puissance comporte au moins un coupleur 3 dB (71) dont les accès (72, 73) de la première paire d'accès conjugués sont respectivement couplés aux sorties (26, 28) des première et deuxième voies d'amplification, le déphaseur ajustable (17) du circuit de traitement étant ajusté de manière à ce que les deux accès de la deuxième paire d'accès du coupleur respectivement couplés à la sortie (24) du circuit de couplage et à une charge (Z) fournissent la somme et la différence algébrique des signaux amplifiés respectivement fournis par les première et deuxième voies d'amplification.

4. Système de transmission, selon l'une des revendications 1 à 3, caractérisé en ce que l'étage d'amplification comporte une troisième voie d'amplification dont l'entrée est couplée à la deuxième sortie (13) du dispositif générateur et la sortie à une troisième entrée (27) du circuit de couplage de puissance, et qui comprend un mélangeur (10) suivi d'un amplificateur (20).

5. Système de transmission selon l'une des revendications 1 à 3, caractérisé en ce que la première sortie (12) du dispositif générateur est couplée à la première voie d'amplification à travers une première entrée et la sortie d'un sommateur (75) dont la deuxième entrée est couplée à la deuxième sortie (13) du dispositif générateur.

6. Système de transmission selon l'une des revendications 1 à 3, caractérisé en ce que la troisième sortie (14) du dispositif générateur est couplée à l'entrée de la deuxième voie d'amplification à travers une première entrée et à la sortie d'un sommateur (75) dont la deuxième entrée est couplée à la deuxième sortie (13) du dispositif générateur.

7. Application du système de transmission selon l'une quelconque des revendications 1 à 6, à un émetteur de télévision, caractérisée en ce que le générateur est un circuit de modulation comportant un premier modulateur (2) ayant une entrée de modulation recevant les informations vidéofréquence et une entrée couplée à la sortie d'un générateur de signal porteur (7), un modulateur supplémentaire (3), recevant les informations audiofréquence et ayant une entrée couplée à la sortie du générateur de signal porteur et une sortie constituant la deuxième sortie (13) du dispositif générateur, la troisième sortie du générateur étant reliée à la sortie du générateur de signal porteur (7) par l'intermédiaire du circuit de traitement.

8. Application du système de transmission selon l'une quelconque des revendications 1 à 6 à un ré-émetteur de télévision, caractérisée en ce que le générateur (1) est un récepteur de signal de télévision comprenant en série un mélangeur (81) alimenté par les signaux haute fréquence à recevoir, un amplificateur à fréquence intermédiaire (82), un séparateur (83) des composantes vidéo et audio ayant une première sortie (85) qui délivre le signal vidéo et une seconde sortie (84), laquelle délivre le signal audio et constitue la deuxième sortie (13) du dispositif générateur (1), des moyens d'écrêtage et de filtrage (86) dont l'entrée est couplée à la sortie vidéo (85) du séparateur (83) et qui fournissent en sortie le signal porteur pur non modulé, et un autre circuit (88) de traitement du signal porteur pur non modulé, connecté à la sortie des moyens d'écrêtage et de filtrage (86) et fournissant en sortie le signal porteur pur non modulé avec un niveau et une phase ajustés, ledit récepteur de signal de télévision comprenant de plus un additionneur (87) qui reçoit sur une première entrée le signal délivré à la sortie vidéo (85) du séparateur (83), sur une seconde entrée, le signal fourni par l'autre circuit de traitement (88), et dont la sortie constitue la première sortie (12) du générateur (1), la troisième sortie (14) de ce dernier étant couplée à la sortie des moyens d'écrêtage et de filtrage (86) par le circuit (15) de traitement du signal porteur pur non modulé, les deux circuits (15, 88) de traitement du signal porteur pur non modulé étant identiques.

**Claims**

1. An am transmission system for a television signal comprising a modulated signal generator (1) supplying, at a first output (12), a carrier signal modulated by the video frequency information and, at a second output, (13), a carrier signal modulated by the audio frequency signal, and furthermore comprising a power amplifying stage, characterized in that the carrier signal modulated by the video frequency information has a carrier level which is less raised than the nominal level, in that the generator (1) supplies, at a third output (14), a non-modulated signal having a predefined level in relation to the level of the modulated carrier signal, a processing circuit (15) being provided to fix the predefined level and the phase of the non-modulated carrier signal, in that the power amplifying state comprises a first amplification path connected with the output (12) of the modulated carrier signal and a second amplification path independent of the first one connected with the output (14) for the non-modulated carrier signal, and in that a power coupling circuit (23) connects the signals issuing from these two paths in order to supply the power amplified signal.

2. The transmission system as claimed in claim 1, characterized in that, the first and the second amplification paths each comprising a mixer (9 and 11) in series with an amplifier (19 and 21), the final stage of the amplifier (19) of the first path is of the AB class and that (21) of the second path is of the B or C class.

3. The transmission system as claimed in claim 2, characterized in that the processing circuit comprises an adjustable phase converter (17) in series with an adjustable attenuator (16), the power coupling circuit comprises at least one 3 dB coupler (71) whose accesses (72 and 73) of the first pair of conjugate accesses are respectively coupled with the outputs (26 and 28) of the first and the second amplification paths, the adjustable phase converter (17) of the processing circuit being adjusted in such a manner that the two accesses of the second pair of accesses of the coupler respectively coupled with the output (24) of the coupling circuit and with a load (Z) supply the algebraic sum and the difference of the amplified signals respectively supplied by the first and the second amplification paths.

4. The transmission system as claimed in any one of claims 1 through 3, characterized in that the amplification stage comprises a third amplification path whose input is coupled with the second output (13) of the generating device and the output is coupled with a third input (27) of the power coupling circuit and which comprises a mixer (10) followed by an amplifier (20).

5. The transmission system as claimed in any one of the claims 1 through 3, characterized in that the first output (12) of the generating device is coupled with the first amplification path via a first input and the output of a summating means (75) whose second input is coupled with the second output (13) of the generating device.

6. The transmission system as claimed in any one of the claims 1 through 3, characterized in that the third output (14) of the generating device is coupled with the input of the second amplification path via a first input and with the output of a summatiing means (75) whose second input is coupled with the second output (13) of the generating means.

7. The application of the transmission system in accordance with any one of the claims 1 through 6 to a television transmitter, characterized in that the generator is a modulation circuit comprising a first modulator (2) having a modulation input receiving the videofrequency information and an input coupled with the output of the carrier signal (7), a supplementary modulator (3), receiving the audiofrequency information and having an input coupled with the output of the carrier signal generator and an output constituting the second output (13) of the generator device, the third output of the generator being connected with the output of

the carrier signal generator (7) by the intermediary of the processing circuit.

8. The application of the transmission system in accordance with one of the claims 1 through 6 to a television relay transmitter, characterized in that the generator (1) is a television signal receiver comprising, in series, a mixer (81) supplied with the high frequency signals to be received, an IF amplifier (82), a separator (83) for video and audio components having a first output (85) which supplies the video signal and a second output (84), which supplies the audio signal and constitutes the second output (13) of the generator device (1), limiting and filtering means (86) whose input is coupled with the video output (85) of the separator (83) and which supply, at the output, the pure non-modulated carrier signal, and another non-modulated pure carrier signal processing circuit (88), connected with the output of the limiting and filtering means (86) and supplying, at the output, the pure non-modulated carrier signal at an adjusted level and phase, the said television signal receiver comprising furthermore an adder (87) which receives, at a first input, the signal supplied to the video output (85) of the separator (83), at a second input, the signal supplied by the other processing circuit (88), and whose output constitutes the first output (12) of the generator (1), the third output (14) of the latter being coupled with the output of the limiting and filtering means (86) by the pure non-modulated carrier signal processing circuit (15), the two circuits (15 and 88) for the processing of the pure non-modulated carrier signal being identical.

**Patentansprüche**

1. Übertragungssystem für amplitudenmodulierte Fernsehsignale, mit einem Modulationssignal-Generator (1), der an einem ersten Ausgang (12) ein durch die Videofrequenzinformation moduliertes Trägersignal, und an einem zweiten Ausgang (13) ein durch das Audiofrequenzsignal moduliertes Trägersignal abgibt und außerdem eine Leistungsverstärkungsstufe umfaßt, dadurch gekennzeichnet,

daß das durch die Videofrequenzinformation modulierte Trägersignal einen niedrigeren Trägerpegel als der Nennpegel hat,

daß der Generator (1) an einem dritten Ausgang (14) ein nicht moduliertes Trägersignal abgibt, das dem Pegel des durch die Videofrequenzinformation modulierten Trägersignals gegenüber einen vorgegebenen Pegel hat, wobei eine Verarbeitungsschaltung (15) zur Festlegung des vorgegebenen Pegels und der Phase des nicht modulierten Trägersignals vorgesehen ist,

daß die Leistungsverstärkungsstufe einen ersten Verstärkerzug umfaßt, der mit dem Ausgang (12) des durch die Videofrequenzinformation modulierten Trägersignals verbunden ist, und einen zweiten, von dem ersten unabhängigen Verstärkerzug, der mit dem Ausgang (14) des nicht modulierten Trägersignals verbunden ist, und

daß eine Leistungskoppelstufe (23) die von diesen beiden Zügen stammenden Signale vereinigt, um das modulierte leistungsverstärkte Signal abzugeben.

2. Übertragungssystem nach Anspruch 1, dadurch gekennzeichnet, daß erster und zweiter Verstärkerzug jeweils einen mit einem Verstärker (19, 21) in Serie geschalteten Mischer (9, 11) umfassen und die Endstufe des Verstärkers (19) des ersten Zugs der Klasse AB und die (21) des zweiten Zugs der Klasse B oder C angehört.

3. Übertragungssystem nach Anspruch 2, dadurch gekennzeichnet, daß die Verarbeitungsschaltung einen einstellbaren Phasenschieber (17) in Serienschaltung mit einem einstellbaren Dämpfungsglied (16), und die Leistungskoppelstufe mindestens einen 3 dB-Koppler (71) umfaßt, dessen Anschlüsse (72, 73) des ersten konjugierten Anschlußpaares jeweils an die Ausgänge (26, 28) des ersten und zweiten Verstärkerzuges gekoppelt sind, wobei der einstellbare Phasenschieber (17) der Verarbeitungsschaltung so eingestellt ist, daß die beiden jeweils an den Ausgang (24) der Koppelstufe und an eine Belastung (Z) gekoppelten Anschlüsse des zweiten Anschlußpaares des Kopplers die Summe und algebraische Differenz der verstärkten Signale ergeben, die jeweils vom ersten und zweiten Verstärkerzug abgegeben werden.

4. Übertragungssystem nach einem der Ansprüche 1 bis 3, dadurch gekennzeichnet, daß die Verstärkungsstufe einen dritten Verstärkerzug umfaßt, dessen Eingang an den zweiten Ausgang (13) des Generators und dessen Ausgang an einen dritten Eingang (27) der Leistungskoppelstufe gekoppelt ist, und das einen Mischer (10) mit einem nachgeschalteten Verstärker (20) umfaßt.

5. Übertragungssystem nach einem der Ansprüche 1 bis 3, dadurch gekennzeichnet, daß der erste Ausgang (12) des Generators an den ersten Verstärkerzug über einen ersten Eingang und den Ausgang eines Summierers (75) gekoppelt ist, dessen zweiter Eingang an den zweiten Ausgang (13) des Generators gekoppelt ist.

6. Übertragungssystem nach einem der Ansprüche 1 bis 3, dadurch gekennzeichnet, daß der dritte Ausgang (14) des Generators an den Eingang des zweiten Verstärkerzugs über einen ersten Eingang und an den Ausgang eines Summierers (75) gekoppelt ist, dessen zweiter Eingang an den zweiten Ausgang (13) des Generators gekoppelt ist.

7. Anwendung des Übertragungssystems nach einem der Ansprüche 1 bis 6 auf einen Fernsehsender, dadurch gekennzeichnet, daß der Generator eine Modulationsschaltung ist, die einen ersten Modulator (2) umfaßt, der einen Modulationseingang für den Empfang von Videofrequenzinformationen hat, und einen mit dem Ausgang eines Trägersignal-Generators (7) gekoppelten Eingang, sowie einen zusätzlichen Modulator (3), der die Audiofrequenzinformationen empfängt und einen an den Ausgang des Trägersignal-Generators gekoppelten Eingang hat und einen den zweiten Ausgang (13) des Generators bildenden Ausgang,

wobei der dritte Ausgang des Generators mittels der Verarbeitungsschaltung mit dem Ausgang des Trägersignal-Generators (7) verbunden ist.

8. Anwendung des Übertragungssystems nach einem der Ansprüche 1 bis 6 auf einen Fernseh-Relaissender, dadurch gekennzeichnet, daß der Generator (1) ein Fernsehsignal-Empfänger ist, der in Serienschaltung einen von den zu empfangenden Hochfrequenzsignalen gespeisten Mischer (81) umfaßt, einen Zwischenfrequenzverstärker (82), eine Trennschaltung (83) der Bild- und Ton-Komponenten mit einem das Bildsignal abgebenden ersten Ausgang (85) und einem das Tonsignal abgebenden zweiten Ausgang (84), der den zweiten Ausgang (13) des Generators (1) bildet, Begrenzer- und Filtermittel (86), deren Eingang an den Bildausgang (85) der Trennschaltung (83) gekoppelt ist und im Ausgang das nichtmodulierte reine Trägersignal abgeben, und eine weitere Schaltung (88) für die Verarbeitung des nicht modulierten reinen Trägersignals, die mit dem Ausgang der Begrenzungs- und Filtermittel (86) verbunden ist und im Ausgang das nicht modulierte reine Trägersignal mit geregeltem Pegel und geregelter Phase abgibt, wobei dieser Fernsehsignalempfänger außerdem einen Addierer (87) enthält, der an einem ersten Eingang das an den Bildausgang (85) der Trennschaltung (83) gegebene Signal empfängt, an einem zweiten Ausgang das Signal, das von der anderen Verarbeitungsschaltung (88) abgegeben wird, deren Ausgang den ersten Ausgang (12) des Generators (1) bildet, wobei der dritte Ausgang (14) desselben mit dem Ausgang der Begrenzungs- und Filtermittel (86) durch die Schaltung (15) für die Verarbeitung des reinen nicht modulierten Trägersignals gekoppelt ist, wobei die beiden Schaltungen (15, 88) für die Verarbeitung des nicht modulierten reinen Trägersignals völlig übereinstimmen.

Fig_1

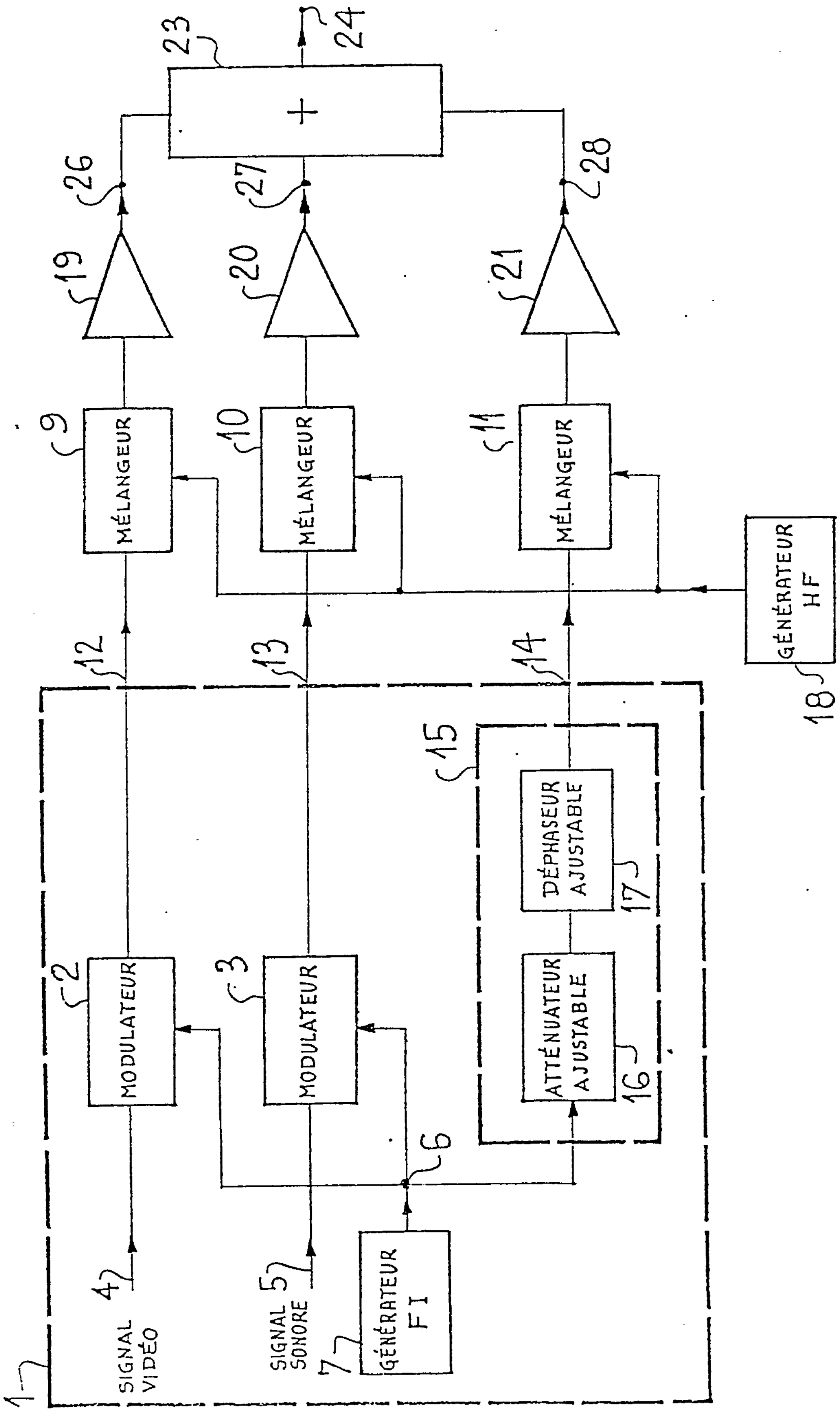
+
MÉLANGEUR
MÉLANGEUR
MÉLANGEUR
GÉNÉRATEUR HF
MODULATEUR
MODULATEUR
DÉPHASEUR AJUSTABLE
ATTÉNUATEUR AJUSTABLE
SIGNAL VIDÉO
SIGNAL SONORE
GÉNÉRATEUR FI
1
2
3
4
5
6
7
9
10
11
12
13
14
15
16
17
18
19
20
21
23
24
26
27
28

Fig-2

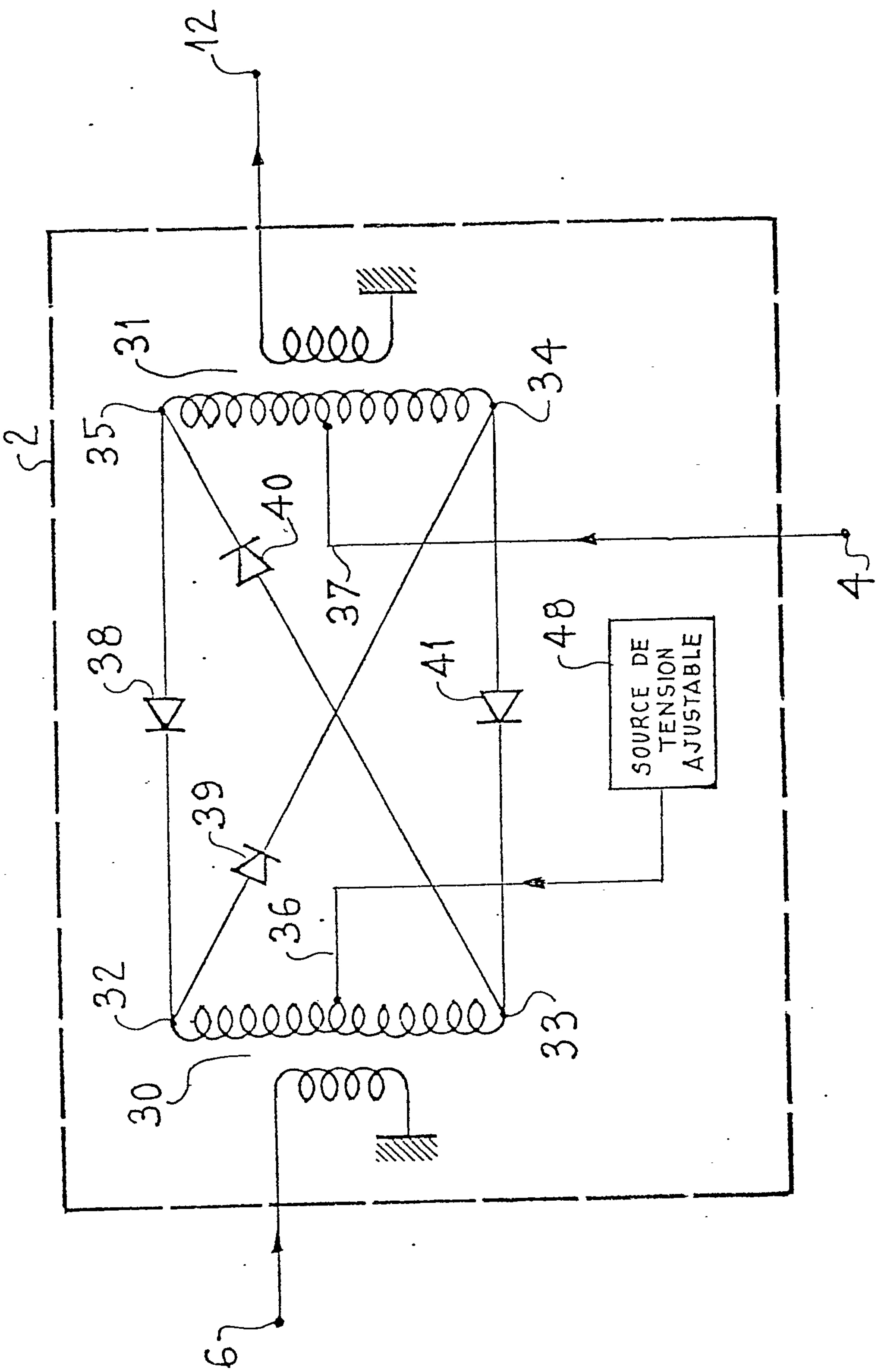
12
2
31
35
34
40
37
4
38
48
41
SOURCE DE
TENSION
AJUSTABLE
39
36
32
33
30
6

FIG_3-a

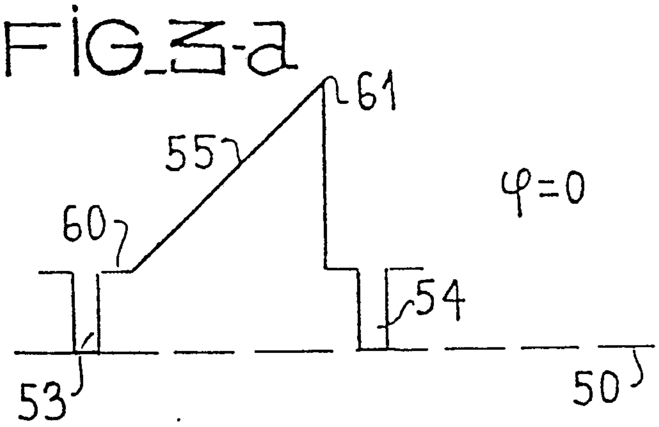


FIG_3-d

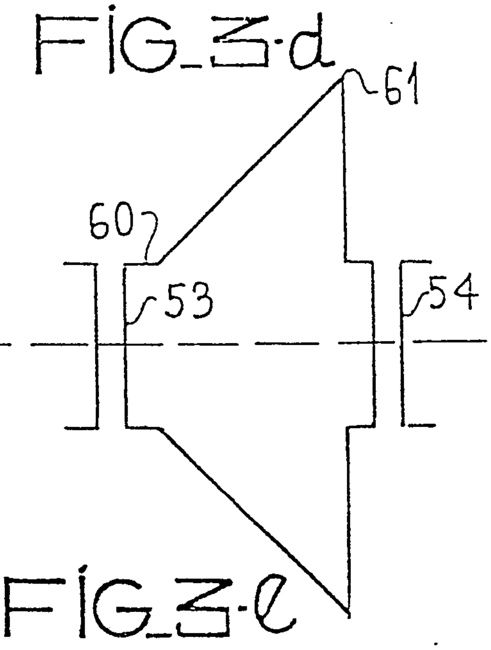


FIG_3-e

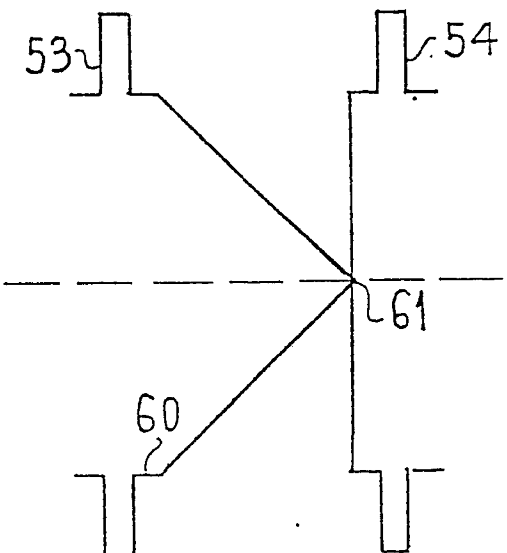


FIG_3-b

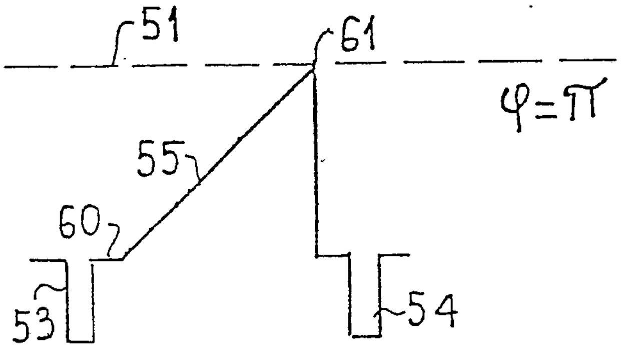


FIG_3-f

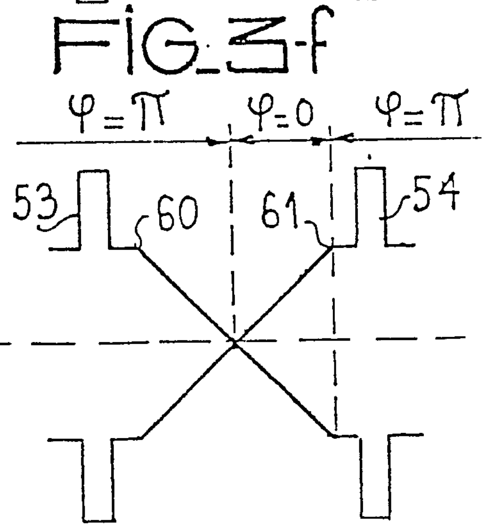


FIG_3-C

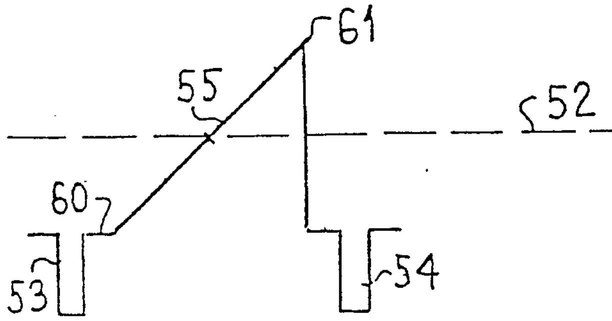

Fig_4

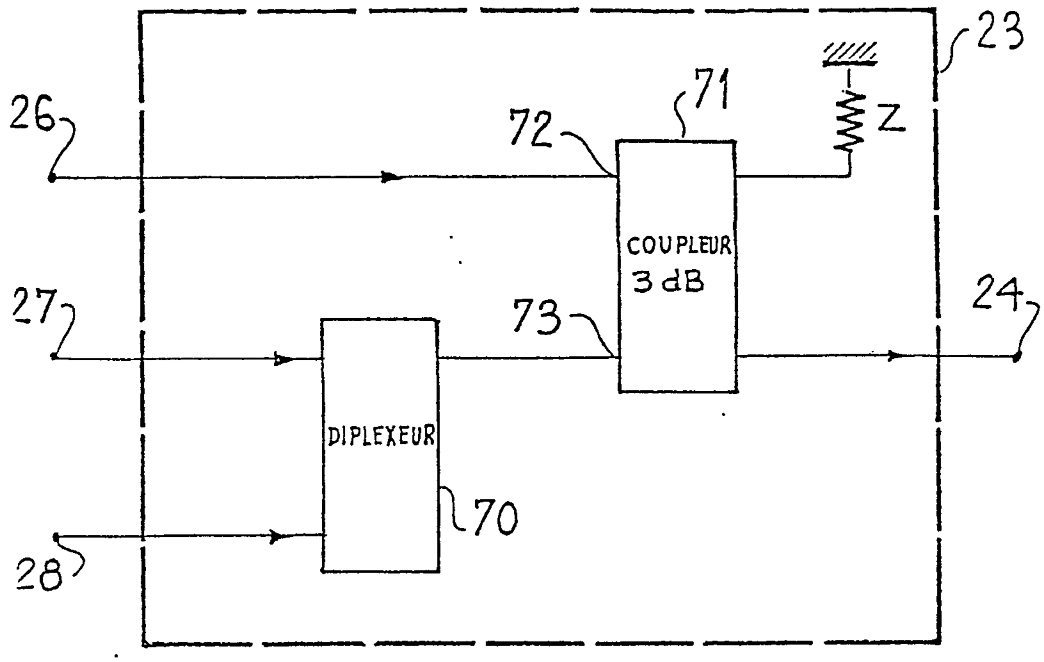
23
26
72
71
Z
COUPLEUR
3 dB
27
73
24
DIPLEXEUR
70
28

Fig_5

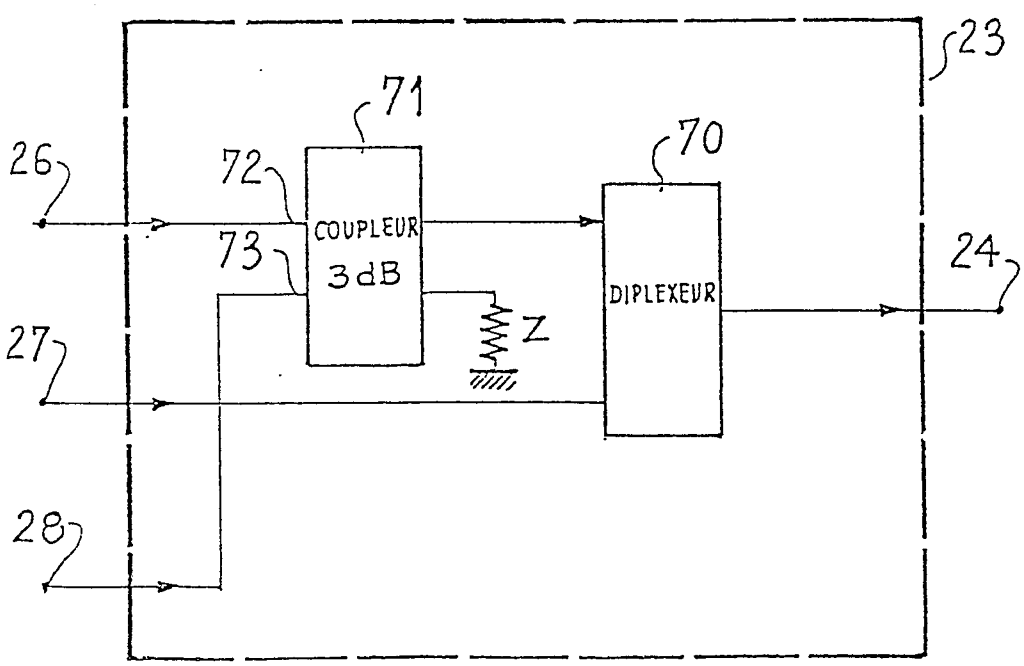
23
71
70
26
72
COUPLEUR
3dB
73
24
DIPLEXEUR
Z
27
28

Fig_6

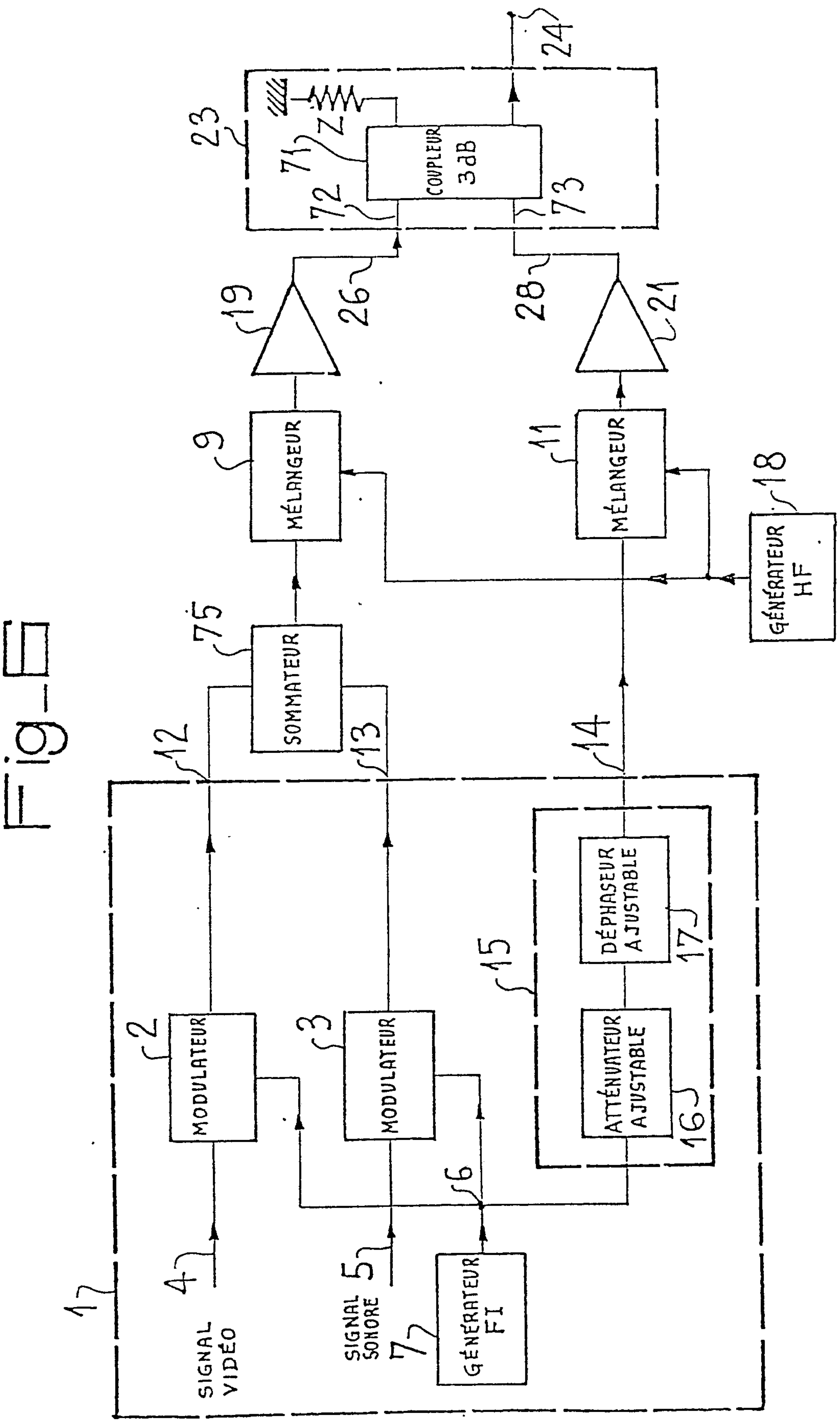
SIGNAL VIDÉO
SIGNAL SONORE
MODULATEUR
MODULATEUR
GÉNÉRATEUR FI
ATTÉNUATEUR AJUSTABLE
DÉPHASEUR AJUSTABLE
SOMMATEUR
MÉLANGEUR
MÉLANGEUR
GÉNÉRATEUR HF
COUPLEUR 3dB
Z
1
2
3
4
5
6
7
9
11
12
13
14
15
16
17
18
19
21
23
24
26
28
71
72
73
75

Fig-7

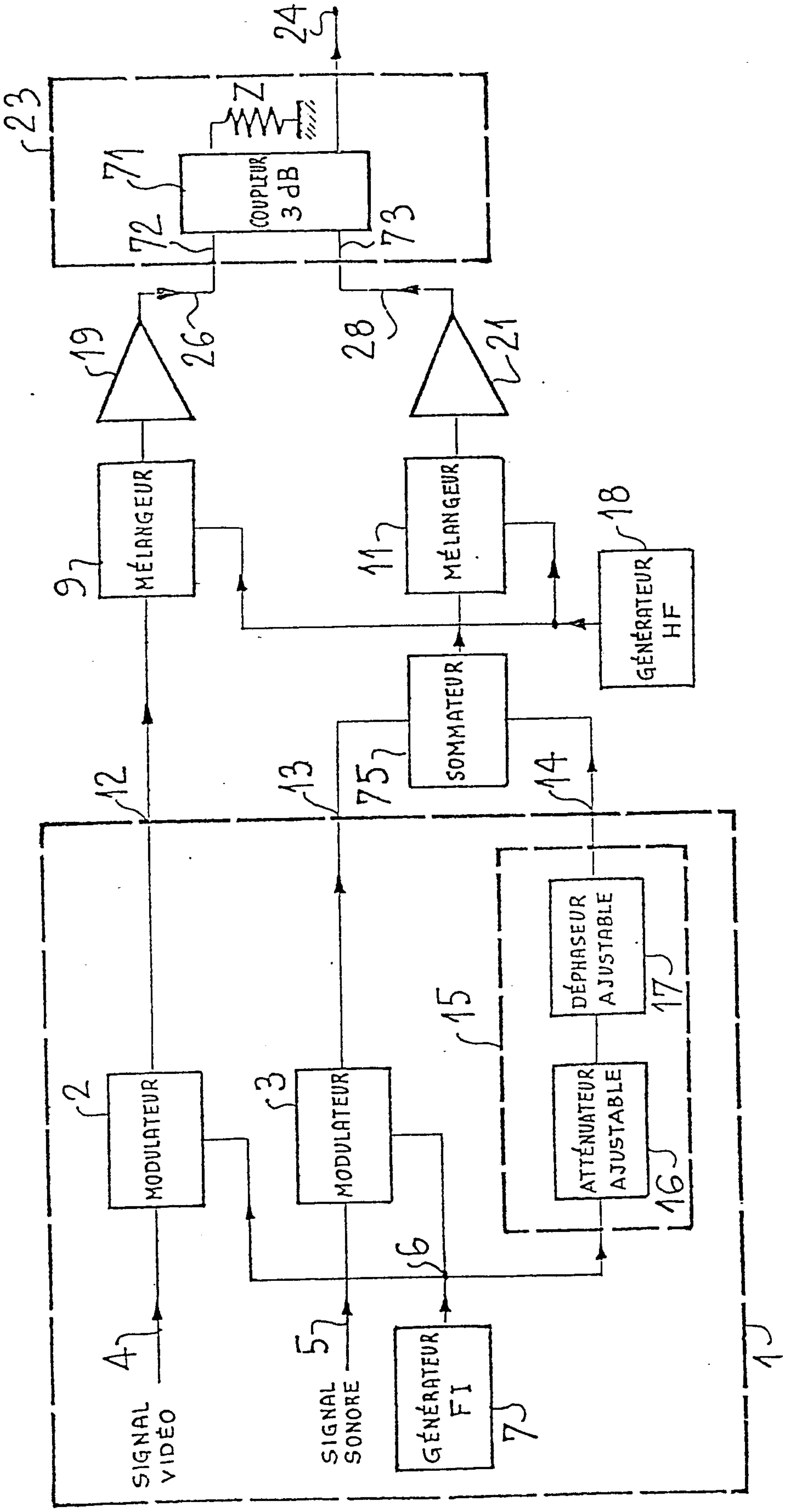
SIGNAL VIDÉO
SIGNAL SONORE
GÉNÉRATEUR FI
MODULATEUR
MODULATEUR
ATTÉNUATEUR AJUSTABLE
DÉPHASEUR AJUSTABLE
SOMMATEUR
MÉLANGEUR
MÉLANGEUR
GÉNÉRATEUR HF
COUPLEUR 3 dB
Z
1
2
3
4
5
6
7
9
11
12
13
14
15
16
17
18
19
21
23
24
26
28
71
72
73
75

Fig_8

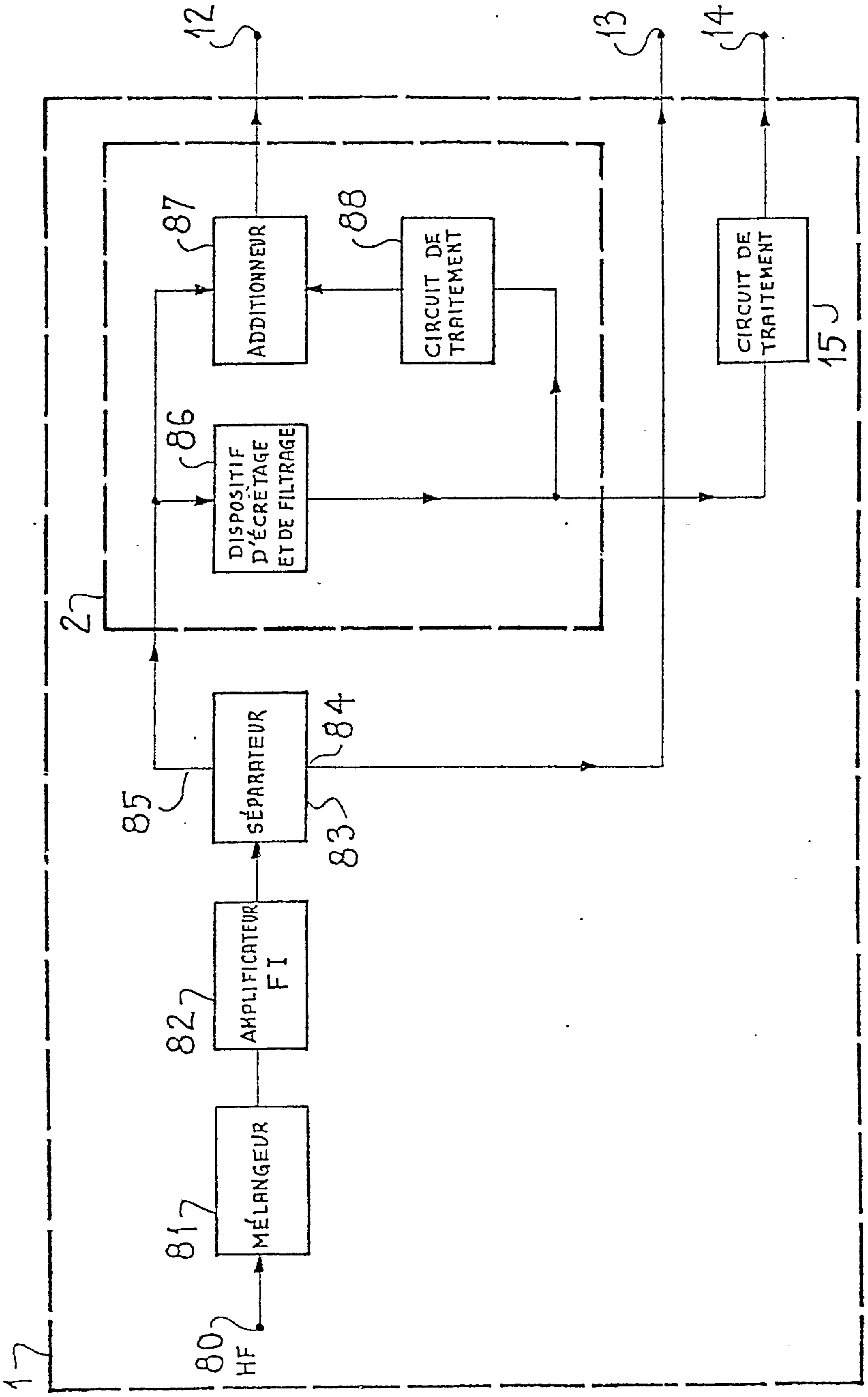

12
13
14
87
ADDITIONNEUR
88
CIRCUIT DE TRAITEMENT
CIRCUIT DE TRAITEMENT
15
86
DISPOSITIF D'ÉCRÊTAGE ET DE FILTRAGE
2
85
SÉPARATEUR
84
83
82
AMPLIFICATEUR FI
81
MÉLANGEUR
80
HF
1